# EUROPEAN PATENT SPECIFICATION

(11) **EP 0 323 200 B1**
(45) Date of publication and mention of the grant of the patent: **26.04.1995**
(21) Application number: 88312325.9
(22) Date of filing: 23.12.1988
(51) Int. Cl.: H03H 17/06

(54) **Circuit and method for sampling frequency conversion**
Schaltung und Verfahren zur Umsetzung der Abtastratenfrequenz
Circuit et procédé pour convertir la fréquence d'échantillonnage

(30) Priority: 29.12.1987 JP 332395/87
(43) Date of publication of application: 05.07.1989
(60) Divisional application: 94101859.0
(73) Proprietor: SONY CORPORATION, Tokyo 141 (JP)
(72) Inventor: Lagadec, Roger c/o Patents Division, Shinagawa-ku Tokyo 141 (JP)
(74) Representative: Cotter, Ivan John

(56) References cited:
- EP-A- 0 084 592
- EP-A- 0 137 323
- IEEE TRANS. ON ACOUSTICS, SPEECH & SIGNAL PROCESSING, vol. ASSP-29, no. 2, April 1981, pages 155-162, IEEE, New York, US; E.B. HOGENAUER: "An economical class of digital filters for decimation and interpolation"
- GRUNDIG TECHNISCHE INFORMATIONEN, vol. 31, no. 1/2, 1984, pages 3-7,Regensburg, DE; GLAAB: "Oversampling-Verfahren der Grundig Compact-Disc-Spieler"

## Description

This invention relates to sampling frequency converters for and methods of converting sampled input data having an input sampling frequency into sampled output data having an output sampling frequency. The invention finds particular use in, for example (but not exclusively), converting between sampling frequencies associated with different pulse code modulation (PCM) audio signal transmission systems.

Various PCM signal transmission systems have been proposed, many of which use different sampling frequencies to digitise and transmit audio signals. For example, the so-called compact disc system encodes an audio signal as a PCM signal recorded at a sampling frequency in the region of about 44.1kHz. As another example, a PCM processor is known in which an input audio signal is sampled at a frequency of 44.056kHz, this sampling frequency being used both to encode and decode a PCM audio signal. As yet another example, broadcast satellite systems are known to broadcast PCM audio signals in what has been designated the A mode at a sampling frequency of 32kHz and at what has been designated the B mode at a sampling frequency of 48kHz. Often, these different PCM samples having different sampling frequencies are to be interchanged such that a PCM signal produced by one system is to be transmitted over a communications system which uses a different PCM sampling frequency, and this signal is to be used eventually by yet another system employing s still different sampling frequency. Thus, the ability to convert PCM signals in particular, and sampled data in general, from one sampling frequency to another, is desirable.

A relatively simple, straightforward sampling frequency converter relies upon digital-to-analog conversion (DAC) of a PCM signal which, subsequently, is re-converted to yet another PCM signal at a desired sampling frequency. That is, an input PCM signal is converted to analog form and the converted analog signal is then sampled at the desired output sampling frequency in an analog-to-digital converter (ADC) to derive a PCM signal with the desired output sampling frequency. Such DAC-ADC processing is relatively complicated and expensive and giving rise to significant deterioration in signal quality. Thus, quantising errors are introduced in each analog-to-digital conversion and these quantising errors are cumulative when an input analog signal first is digitised, then converted to analog form and then re-digitised, all for the purpose of modifying the sampling frequency of the resultant PCM audio signal.

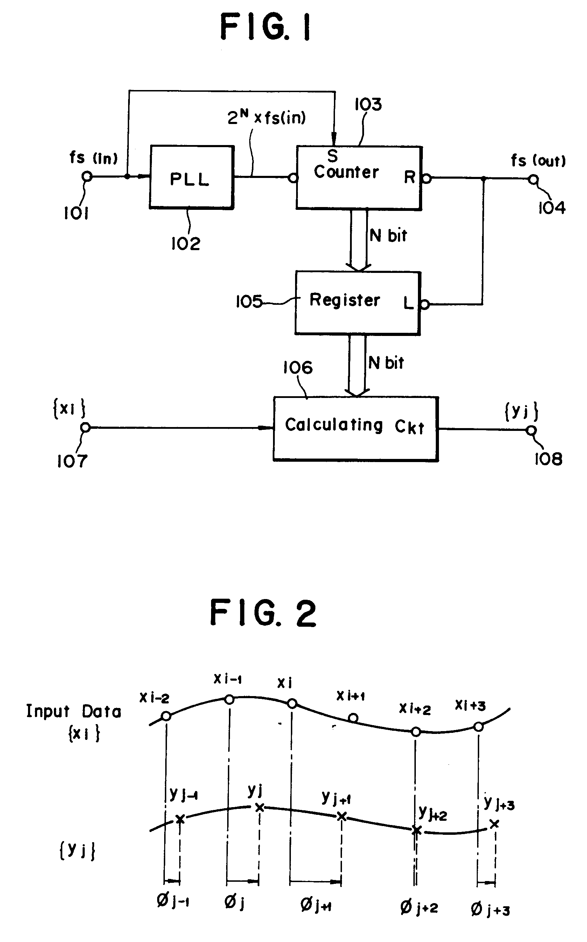

Digital converters by which an input PCM signal is converted to a digital signal of desired sampling frequency, without requiring an intermediate analog conversion step, are known. One example is shown in Figure 1 of the accompanying drawings, which shows a sampling frequency converter disclosed in Japanese Patent Applications Publication Nos. 57-115 015 and 61-204 700. The sampling frequency converter shown in Figure 1 is supplied with an input sampling clock signal Fs(in) having an input sampling frequency fs(in) and with an output sampling clock signal Fs(out) having an output sampling frequency fs(out). A sequence of input data samples xᵢ with the input sampling frequency fs(in) is applied to an input terminal 107 and converted to a sequence of output data sample Yⱼ having the output sampling frequency fs(out). A phase locked loop (PLL) 102 receives the input sampling clock signal supplied to a terminal 101 and multiplies the input sampling frequency fs(in) by a factor 2^{N} (where, for example, N = 7). As a result, the PLL 102 produces a high frequency clock signal of a frequency 2^{N}.fs(in). This high frequency clock signal is supplied to a counter 103 which is set in response to each pulse of the input sampling clock signal Fs(in) (applied to a set input S) and is reset in response to each pulse of the output sampling clock signal Fs(out). The output sampling clock signal is supplied to a reset input R of the counter 103 and also to a latch input L of a N-bit register 105. The output of the counter 103 is coupled to the register 105 and the count reached by the counter is transferred to and latched in the register upon the occurrence of an output sampling clock pulse.

As a result, the count reached by the counter 103 and latched in the register 105 is representative of the phase of the output sampling clock pulse with respect to the immediately preceding input sampling clock pulse. That is, the phase difference between the output sampling point and the immediately preceding input sampling point is represented by the N-bit count which is normalised to unity. This N-bit normalised phase difference is supplied to a calculating circuit 106.

The calculating circuit 106 functions to convert the input data sample xᵢ to output data samples yⱼ in response to each N-bit normalised phase difference supplied thereto by the register 105. The converted output data samples are obtained at an output terminal 108.

The relationship between the N-bit phase data stored in the register 105 and represented as phase data øⱼ, the input data samples xᵢ and the output data samples Yⱼ are graphically depicted in Figure 2 of the accompanying drawings. Of course, if the input data samples are converted to analog form, the resultant analog signal would, ideally, be identical to the analog representation of the output data sample yⱼ. The calculating circuit 106 functions to calculate the sample value of an output data sample yⱼ at an output sampling point in response to an input data sample xᵢ by using multinomial interpolation or digital filtering, as described below.

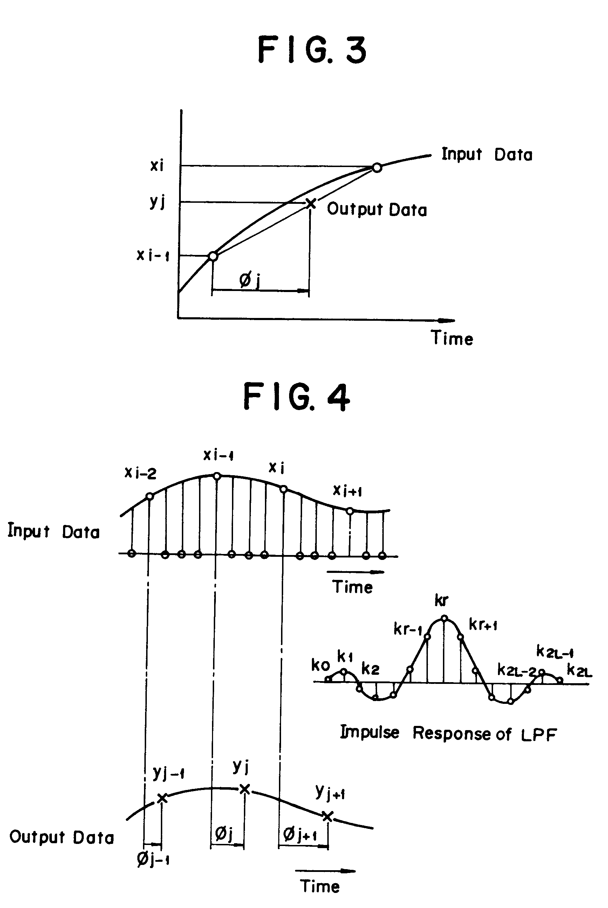

As an example, and with reference to Figure 3 of the accompanying drawings, a method of calculating an approximate value of an output data sample by multinomial interpolation is represented. Here, the multinomial interpolation is interpolation of the first degree, commonly referred to as linear interpolation. From Figure 3, it can be seen that sample xᵢ and xᵢ₋₁ represent amplitudes of the input data samples, yⱼ represents an amplitude of an output data sample, and øⱼ represents the phase of an output sample point relative to the immediately preceding input sample point (0 ≦ øⱼ <1). The amplitude yⱼ of the output sample point may be expressed as:${\text{y}}_{\text{j}} {\text{= x}}_{\text{i-1}} {\text{+ (x}}_{\text{i}} {\text{- x}}_{\text{i-1}} {\text{). ø}}_{\text{j}} \text{.}$
Thus, the output amplitude at a desired output sample point may be calculated from the data input amplitudes xᵢ and xᵢ₋₁ and from the phase data øⱼ.

An example of digital filtering is represented by the waveforms shown in Figure 4 of the accompanying drawings. Here, the input-to-output sampling frequency conversion ratio is assumed to be L/M, wherein L and M are integers. Sampling frequency conversion is carried out as follows:

First, L-1 zero-valued samples are filled in between adjacent samples of the input sampling sequence xᵢ. As a consequence of such processing, the apparent sampling frequency is increased by a factor L but the spectrum of the input sampling sequence remains unchanged. The sampling sequence with this increased sampling frequency then is convolved with (or multiplied by) a coefficient sequence K₀, K₁, K₂, ..., kᵣ, ..., K₂ᵣ₋₁, K₂ᵣ which are samples of the impulse response of a low-pass filter having a pass band which passes the lower of the input sampling frequency fs(in) or the output sampling frequency fs(out) in a range of up to L/2 times the passed sampling frequency. As a result of this multiplication processing, interpolated sample data having a sampling rate which is L times that of the input sampling frequency is obtained.

The interpolated sample data yⱼ′, whose sampling rate is L times the input rate, may be represented as:${\text{y}}_{\text{j}} {\text{= ... + x}}_{\text{i-2}} {\text{.K}}_{\text{r+L-L}} {\text{. ø}}_{\text{j}} {\text{+ x}}_{\text{i-1}} {\text{.K}}_{\text{r-L}} {\text{. ø}}_{\text{j}} {\text{+ x}}_{\text{i}} {\text{.K}}_{\text{r-L-L}} {\text{. ø}}_{\text{j}} {\text{+ x}}_{\text{i+1}} {\text{.K}}_{\text{r-2L-L}} {\text{. ø}}_{\text{j}} \text{+ ...} {\text{[ø}}_{\text{j}} \text{= ø/L, 1/L, 2/L, ... , (L-1/L)].}$
In order to calculate the amplitude of one output sample, the Lth coefficients may be extracted and summed in a summation of products process that may be carried out by a digital signal processor (DSP). Then, the amplitude of the L-th output sample may be reduced by a factor 1/M, to produce an output data sample yⱼ whose sampling frequency is converted to L/M relative to the input sampling frequency. By performing the foregoing calculation for each output sample point once for each M input data samples, the number of calculations can be reduced by the factor 1/M.

Obtaining the output sampling sequence yⱼ by the above-mentioned convolution calculation generally relies upon a high speed clock signal which generated by increasing the input sampling frequency (or the output sampling frequency) many times. This multiple of the input data sampling frequency (or output data sampling frequency) is used to drive the digital signal processor.

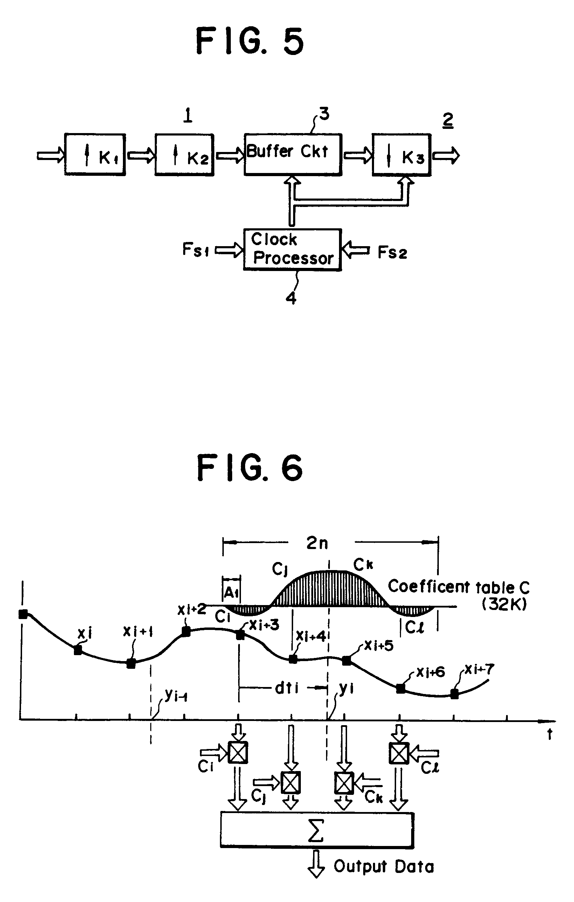

Another example of a previously proposed sampling frequency converter is illustrated in Figures 5 to 7 of the accompanying drawings. In this example, the input data sequence is over-sampled by a fixed ratio, for example by a factor of 4, and the oversampled input data sequence is supplied to a buffer circuit from which four data samples are read, each being multiplied by a coefficient related to the phase different between an input sampling clock signal Fs1 and an output sampling clock signal Fs2. The products are summed, thereby producing the desired output data sequence at the selected output sampling frequency, with the resultant output samples each exhibiting proper amplitude values.

As shown in figure 5, input data having an input sampling rate fs1 is supplied to a two-stage fixed ratio over-sampling filter 1 and is converted into data whose sampling frequency is a multiple of the input sampling rate. A first stage of the over-sampling filter 1 operates to increase the input sampling frequency by a factor K1 and, thus, may be considered a K1-times over-sampling filter. Likewise, a second stage of the filter 1 functions to increase the sampling rate of the samples supplied thereto from the first stage by a factor K2 and may be considered a K2-times over-sampling filter. In a typical embodiment, K1 = K2 = 2, resulting in an increase in the input sample ratio by a factor of 4. The output of the over-sampling filter 1 is supplied to a buffer circuit or buffer 3. Within a period Ts1 of the input sampling clock signal Fs1, there are included four samples of the oversampled input data, and these four samples are read out from the buffer 3 during the period Ts1. The buffer write-in and read-out operations are controlled by an output of a clock processor 4.

The four samples read from the buffer 3 are multiplied by predetermined coefficients in a digital filter 2, the latter also being controlled by clock processor 4. As a result of this multiplication operation, output data samples having the desired sampling rate of Fs2 are obtained.

The instantaneous relative time different dtᵢ between the input sampling clock signal Fs1 and the output sampling clock signal Fs2, that is between the input and output data samples, is detected by the clock processor 4. Based upon this relative time difference dtᵢ, the buffer 3 and digital filter 2 are controlled in the manner described below.

Figure 6 is a waveform diagram useful for understanding the operation of the digital filter 2. In Figure 6, the oversampled input data samples are represented as samples xᵢ, xᵢ₊₁, ... having a sampling rate 4fs1; and output data samples Yᵢ₋₁, Yᵢ, ... exhibit the sampling rate of Fs2 and are produced at times relative to the oversampled samples xᵢ, xᵢ₊₁, etc. The amplitude of an output sample yᵢ is obtained by multiplying four oversampled samples xᵢ₊₃, xᵢ₊₄, xᵢ₊₅ and xᵢ₊₆ by coefficients cᵢ, cⱼ, cₖ and cₗ, respectively, and then adding all of these products together. The coefficients cᵢ, cⱼ, etc. are samples of the impulse response of a low pass filter, similar to that shown in Figure 4, represented by, for example, 32K samples. These coefficient samples are stored in a coefficient table C which is shifted so that its centre coincides with the time at which the output sample yᵢ is produced. Then, the coefficients cᵢ, cⱼ, cₖ and cₗ are selected from the coefficient table C at the times that oversampled data samples xᵢ₊₃, xᵢ₊₄, etc. are read from the buffer 3.

The relative time difference dt between an input data sample, assumed to be the sample xᵢ₊₃, and an output sample yᵢ (the precise position where an output sample amplitude is to be calculated) cannot be measured accurately due to clock jitter or the like. A time-related error in determining the position of the output sample causes an amplitude error in the sample amplitude calculation. This amplitude error must be kept below one quantising step. That is, the least significant bit in an output sample cannot be erroneous. Since the relative time difference dt cannot be measured, it must be calculated to an accuracy of virtually 16 bits.

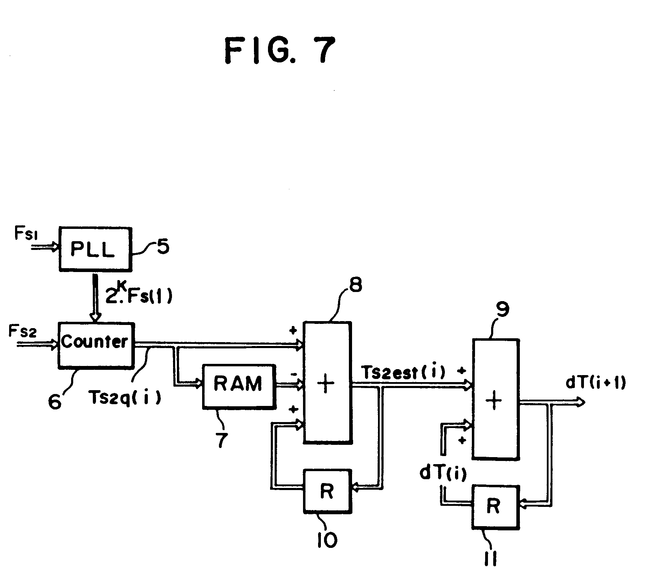

Figure 7 is a block diagram of an example of a previously proposed clock processor 4 used to provide an error-free updating of relative time difference dt(i) carried out by measuring and averaging the output sampling period Ts2 and accumulating relative time differences dt. The clock processor 4 of Figure 7 includes a phase locked loop (PLL) 5, a counter 6, a random access memory (RAM) 7, adders 8 and 9 and delay circuits 10 and 11. The PLL 5 generates a clock signal whose frequency is a multiple of the input sampling frequency fs1, that is, a clock frequency equal to 2^{k}fs1. This clock signal is used to measure the period Ts2 of the output sampling frequency fs2. This measured period, which is designated Ts2q(i), is coarsely quantised with an accuracy of 6 to 7 bits. The measured output sampling period Ts2q(i) is averaged over a time period sufficiently long to increase its resolution to 16 bits (or more), and this averaged output sampling period is designated Ts2(est)(i). The average value Ts2(est)(i) must be measured such that no systematic down-rounding or up-rounding occurs over several samples, because values due to such up-rounding or down-rounding accumulate as errors. To obtain the average value of the clock period Ts2, a simple finite impulse response (FIR) averaging circuit, for example one with a z-Transform${\text{H(z) = (1 - z}}^{\text{-n}} \text{)/(1 - z⁻¹)}$
can be used. One advantage to such FIR averaging circuits is that they introduce no quantisation error. In Figure 7, the RAM 7, adder 8 and delay circuit 10 function as averaging circuitry, and the value Ts2(est)(i) is provided at the output of the adder 8.

When starting from an arbitrary or defined initial value dt(O), the relative time difference dt between input and output data samples is updated as$\text{dt(i+1) = [dt(i) + Ts2(est)(i)] Mod(Ts1).}$
With numerical values normalised to a unit of Tsl = 1, the modulo operation requires no additional hardware.

In the above-described previously proposed examples, calculation and control of the output data samples are carried out as a function of the relative time difference dtᵢ, and this relative time difference dtᵢ is determined from the input sampling clock signal Fsl and the output sampling clock signal Fs2. That is, once the time difference dtᵢ is calculated, it is used to generate addresses for the filter coefficients which, in turn, are used to multiply the oversampled input data samples to calculate the output data samples. This technique suffers from several disadvantages. The overall calculating process is complex and time-consuming. Also, since the read/write operations of the buffer have been controlled as a function of the time difference dtᵢ produced by the clock processor 4 (Figure 5), such read/write control has been complicated.

European Patent Application Publication No. EP-A-0 137 323 (which corresponds to US Patent No. US-A-4 825 398) discloses a sampling frequency converter for converting sampled input data having an input sampling frequency into sampled output data having a selected output sampling frequency. The converter comprises a time measuring circuit which calculates the ratio of the time differences between the input and output scanning sequences and generates an output signal representing the ratio, and a compensation circuit which averages the output signal of the time measuring circuit to generate an averaged output. The time measuring circuit and an interpolator (coefficient composer) circuit continuously calculate interpolated filter coefficients which are supplied to a filter for converting the sampled input data into the sampled output data. A modulo adder, interposed between the compensation circuit and the interpolator circuit, comprises a series connection of an adder and a register which act to mix two successive values of the averaged output from the compensation circuit prior to supply to the interpolator circuit as so-called m values. In the interpolator circuit, a divider circuit splits the m values into s values indicating the nearest filter coefficient and a values indicating the distance between the next following filter coefficient and the input scan value. So-called v values and the s values are used to address a memory which stores both a limited number of filter coefficients and differences between two adjacent filter coefficients. The addressed difference is multiplied by an a value and then added to the addressed filter coefficient to produce a completely interpolated filter coefficient.

According to a first aspect of the invention there is provided a sampling frequency converter for converting sampled input data having an input sampling frequency into sampled output data having a selected output sampling frequency, the converter comprising:
circuit means for determining a relative ratio between periods of input data samples and output data samples and generating an output signal representing the relative ratio;
averaging means for averaging said output signal of said circuit means for a predetermined time duration and generating an averaged output;
filter coefficient generating means responsive to said averaged output for generating data representative of a set of predetermined filter coefficients derived from a low pass filter impulse response, said filter coefficient generating means including an addressable memory for storing said set of predetermined filter coefficients, means for providing a fixed value as a function of said generated averaged output, and adder means for adding said averaged output, said fixed value and an output of said adder means for generating a memory address for reading out a filter coefficient; and
sampling filter circuit means for converting said sampled input data into said sampled output data in response to said filter coefficients.

According to a second aspect of the invention there is provided a method of converting sampled input data having an input sampling frequency into sampled output data having a selected output sampling frequency, the method comprising the steps of:
determining a relative ratio between a period of the input data samples and a period of the output data samples;
averaging said relative ratio for a predetermined time duration;
generating predetermined filter coefficients derived from a low pass filter impulse response in response to the averaged relative ratio, said generation of predetermined filter coefficients comprising storing in addressable memory a set of predetermined filter coefficients, providing a fixed value as a function of the averaged relative ratio, generating a summation output by adding the averaged relative ratio, said fixed value and said summation output, and using the summation output to generate a memory address; and
converting said sampled input data into said sampled output data in response to said filter coefficients.

An embodiment of the invention described in detail below seeks to provide a sampling frequency conversion technique which overcomes or at least alleviates the above-noted drawbacks and disadvantages. The technique converts a signal sampling frequency without relying upon the time difference between input and output data samples. The technique generates addresses for selecting filter coefficients used for sampling frequency conversion in accordance with a relatively simple yet accurate implementation. The sampling frequency conversion operation suffers from minimal quantisation error.

The invention will now be further described, by way of illustrative and non-limiting example, with reference to the accompanying drawings, in which:
Figure 1 is a block diagram, described above, of a previously proposed sampling frequency converter;
Figures 2 to 4, described above, are diagrams useful for understanding the operation of the sampling frequency converter of Figure 1;
Figure 5, described above, is a block diagram of another previously proposed sampling frequency converter;
Figure 6, described above, is a diagram useful for understanding the operation of the sampling frequency converter of Figure 5;
Figure 7, described above, is a block diagram of a clock processor that can be used in the sampling frequency converter of Figure 5;
Figure 8 is a block diagram of a clock processor for a sampling frequency converter embodying the invention;
Figure 9 is a block diagram of an embodiment of an overflow check circuit shown in Figure 8;
Figure 10 is a waveform diagram useful for understanding the operation of the circuit shown in Figure 9;
Figure 11 is a block diagram of another embodiment of the overflow check circuit shown in Figure 8; and
Figure 12 is a waveform diagram useful for understanding the operation of the circuit shown in Figure 11.

Reverting to Figure 6, the first coefficient cᵢ of the four coefficients cᵢ, cⱼ, cₖ and cₗ is stored at an address A1 of the coefficient table C. The address A1 is related to the relative time difference dt(i) between the input data sample xᵢ₊₃ and the time of occurrence of the output data sample yᵢ as follows:$\text{A1 + dt(i) = 0.5 x Ts1}$$\text{A1 = 0.5Ts1 - dt(i).}$
It will be recognised that the address Al is a positive quantity and always is less than 0.25. Accordingly, a more general formula for the address A1 is:$\text{A1 = (Ts1 - dt(i)) Mod Ts1.}$
Al is the complement of dt(i) Mod Ts1; and the calculation of dt(i), as was done in the above-described prior proposal, can be replaced by direct calculation of the address A1. The other addresses of the coefficient table, sometimes referred to herein as filter addresses, are:$\text{A2 = (A1 + 0.25) Mod Ts1}$$\text{A3 = (A2 + 0.25) Mod Ts1}$$\text{A4 = (A3 + 0.25) Mod Ts1.}$
In the foregoing equations, since A1 is less than 0.25, the modulo operation is not actually needed.

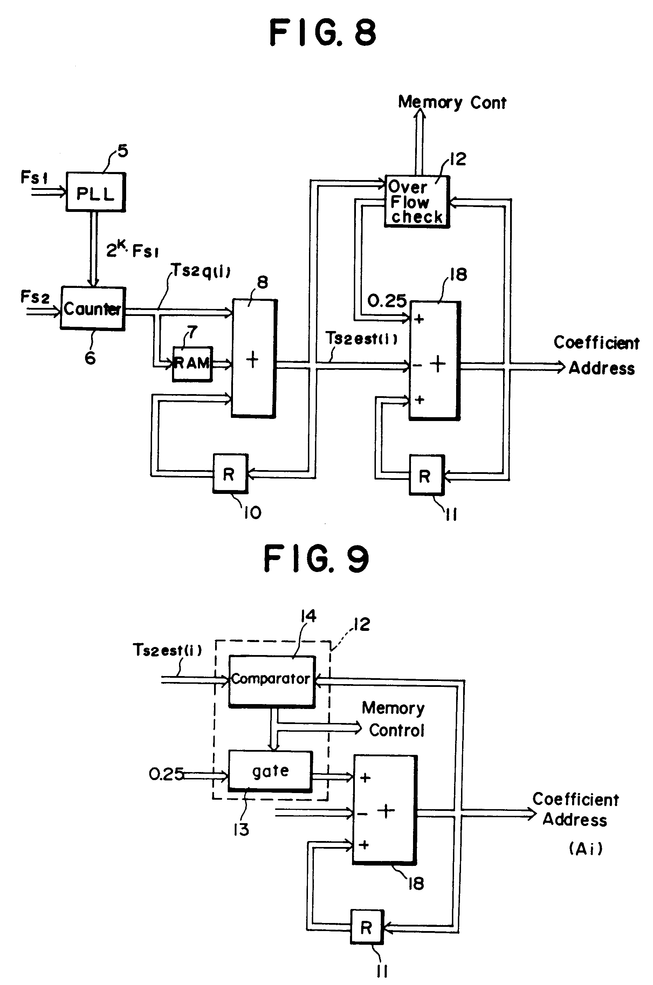

An embodiment of the invention uses a clock processor shown in Figure 8 which differs from the previously proposed clock processor shown in Figure 7 in that the coefficient address as well as the buffer control are obtained directly from the averaged output sampling period Ts2(est)(i), produced at the output of the adder 8. Whereas the previous proposal used the averaged output sampling period Ts2(est)(i) to calculate the relative time difference dt(i) which then was used to generate addresses Ai, the present embodiment avoids the complex and time-consuming steps needed in the calculation of dt(i).

Those elements shown in Figure 8 which are the same as those described above with reference to Figure 7 are identified by the same references. The description of these elements is not repeated. From Figure 8, it can be seen that the output of the adder 8 is coupled to an adder 18 which calculates the coefficient address used to read out the appropriate filter coefficient which, in turn, is used to multiply the input data sample to effect a sampling frequency conversion. The coefficient address is fed back to the adder 18 by way of a delay circuit 11. The adder output also is supplied to an overflow check circuit 12 which selectively couples a fixed value to the adder 18 for summation with the other inputs supplied to the adder 18, depending upon the presence or absence of a detected overflow.

It will be appreciated that a sampling frequency conversion operation may increase the input sampling frequency, referred to herein as an "up convert", or may decrease the input sampling frequency, referred to as a "down convert". An embodiment of the overflow check circuit 12 for carrying out an up convert will be described first.

Let is be assumed that the output sampling period Ts2 is 0.9 times the input sampling period. That is, the sampling frequency is increased by a factor 10/9. Referring to Figure 9, the overflow check circuit 12 used to carry out an up convert includes a comparator 14 which compares the coefficient address A1 produced by the adder 18 with the averaged output sampling period Ts2(est)(i) generated by the adder 8(Figure 8). When the coefficient address Ai is less than the averaged output sampling period Ts2(est)(i), the constant value 0.25 is added to the coefficient address so as to generate the next coefficient address. Conversely, when the coefficient address Ai is greater than the averaged output sampling period Ts2(est)(i), the constant value 0.25 is not added to the coefficient address. Thus, depending upon the output of the comparator 14, the constant numerical value 0.25 is selectively supplied to the adder 18 through a gate circuit 13 having an enable input coupled to the comparator.

The delay circuit 11 imparts a time delay of one period of the increased input sampling frequency, corresponding to one period of each sample that has been oversampled by the factor 2^{k} = 4. When the input and output sampling frequencies are relatively close to each other, as in the example assumed herein, the coefficient addresses A1, A2 and A3 will not be larger than the averaged output sampling period Ts2(est)(i), but the coefficient address A4 possibly may be larger than the averaged output sampling period Ts2(est)(i). At the time that the coefficient address A4 is obtained at the output of the adder 18, the averaged output sampling period Ts2(est)(i) is supplied to the adder to be subtracted from the other values then supplied thereto. The averaged output sampling period Ts2(est)(i) is not supplied to the adder 18 at the time that the addresses A1, A2 and A3 are generated.

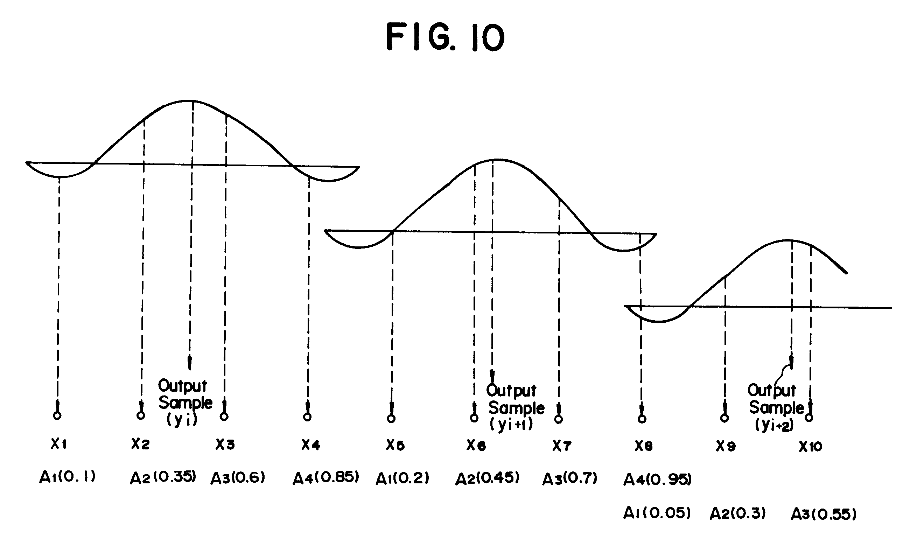

To facilitate an understanding of the operation of Figure 9, the operation will now be described with reference to specific examples of numerical values. These values are normalised, that is the input sampling period Ts1 is normalised to unity, resulting in the averaged output sampling period Ts2(est)(i) becoming approximately 0.9. Referring to Figure 10, input data samples x₁, x₂, ... represent the oversampled input data samples and the output data samples are represented as yᵢ, yᵢ₊₁, yᵢ₊₂, etc. The amplitudes of these three consecutive output data samples are to be calculated to effect proper frequency conversion. The relative times of occurrences of the output data samples and the oversampled input data samples are as illustrated. Furthermore, the low pass filter impulse response of the period Ts1 is seen to be shifted so as to be centred at each output data sample. The amplitude of the impulse response at the time of occurrence of each oversampled input data sample is the filter coefficient with which that input data sample is multiplied. Closely spaced samples of the impulse response amplitude are stored in an addressable memory; and the address used to read out a respective sample is generated by the adder 18.

In calculating the amplitude of the output data sample yᵢ, the address of the coefficient to be multiplied by the oversampled input data sample xᵢ is assumed to be 0.1. Then, the addresses of the coefficients to be multiplied by the subsequent oversampled input data samples x₂, x₃ and x₄ become:$\text{A2 = A1 + 0.25 = 0.35}$$\text{A3 = A2 + 0.25 = 0.6}$$\text{A4 = A3 + 0.25 = 0.85}$
In this case, each of the coefficient addresses A1 to A4 is less than the averaged output sampling period Ts2(est)(i), which has been defined as 0.9. Hence, the comparator 14 determines that each of these addresses Ai is smaller than the averaged output sampling period Ts2(est)(i) and this activates gate 13. As a result, the coefficient address A4 and the constant value 0.25 are supplied as positive values to the adder 18, while the averaged output sampling period Ts2(est) (i) is supplied as a negative value to the adder. Hence, the address A1 of the first coefficient for calculating the next output data sample yᵢ₊₁, that is the address A1 of the coefficient to be multiplied by the next oversampled input data sample x₅, becomes:$\text{A1 = A4 + 0.25 - Ts2(est)(i)} \text{= 0.85 + 0.25 - 0.9 = 0.2.}$
In the manner discussed above, the addresses A2, A3 and A4 of the coefficients to be multiplied by the subsequent oversampled input data samples x₆, x₇ and x₈ become:$\text{A2 = A1 + 0.25 = 0.45}$$\text{A3 = A2 + 0.25 = 0.7}$$\text{A4 = A3 + 0.25 = 0.95.}$
Now, the address A4 of the coefficient to be multiplied by the oversampled input data sample x₈ has been calculated as 0.95 and is larger than the averaged output sampling period Ts2(est)(i) which has been assumed to be 0.9. Hence, the comparator 14 functions to disable the gate 13. As a consequence, in calculating the address A1 of the next coefficient which will be used to calculate the next output sample yᵢ₊₂, the value 0.25 is not added to the previous coefficient address A4. Rather, only the averaged output sampling period Ts2(est) (i) is subtracted from the coefficient address A4. As can be seen from Figure 10, the oversampled input data sample to be multiplied by the coefficient stored at the address A1 is not the next sample x₉ but, rather, the input data sample x₈ is used once again. Thus, the address A1 of the coefficient to be multiplied by the oversampled input data sample x₈ for calculating the output sample yᵢ₊₂ becomes:$\text{A1 = A4 - Ts2(est)(i)} \text{= 0.95 - 0.9 = 0.05.}$
As will be understood from the example just described, the output of the comparator 14 indicates whether an oversampled input data sample is to be used again and, thus, the comparator output is used to control the read/write operation of the buffer 3 shown in Figure 5.

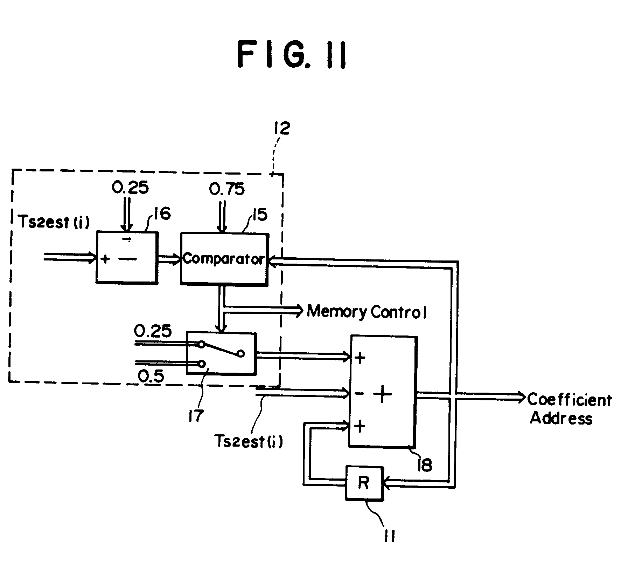

Next, an embodiment of the overflow check circuit 12 will be described for the arrangement wherein a down convert of the sampling frequency is to be carried out. For example, let it be assumed that the output sampling period Ts2 is increased to be equal to 1.1 times the input sampling period Ts1. That is, the sampling frequency is reduced by a factor 10/11. To carry out this down convert, the overflow check circuit 12 is configured as shown in Figure 11. Here, a subtracter 16 functions to subtract the fixed constant value 0.25 from the averaged output sampling period Ts2(est)(i) to obtain a value which, along with a constant value 0.75, is compared in a comparator 15 to be coefficient address Ai produced by the adder 18. The comparator 15 is coupled to a selector 17 to control the operation of the selector for supplying to the adder 18 either a constant value of 0.25 or a constant value of 0.5. More particularly, the selector 17 responds to the output of the comparator 15 to select the constant value 0.5 when the coefficient address Ai complies with the relationship:$\text{0.75 < Ai < Ts2 (est)(i) - 0.25.}$
The selector 17 also responds to the output of the comparator 15 to supply to the adder 18 the constant value 0.25 when the coefficient address Ai is determined to comply with the relationships:$\text{Ai ≦ 0.75 or Ai ≧ Ts2(est)(i) - 0.25.}$
The constant value selected by the selector 17 is added to the coefficient address Ai by the adder 18.

As described above, the coefficient addresses A1, A2 and A3 each exhibit a value less than 0.75. Hence, when the adder 18 generates the coefficient address A1 or A2 or A3, the selector 17 selects the constant value 0.25 to be added to the preceding coefficient address which is fed back to the adder 18 by the delay circuit 11.

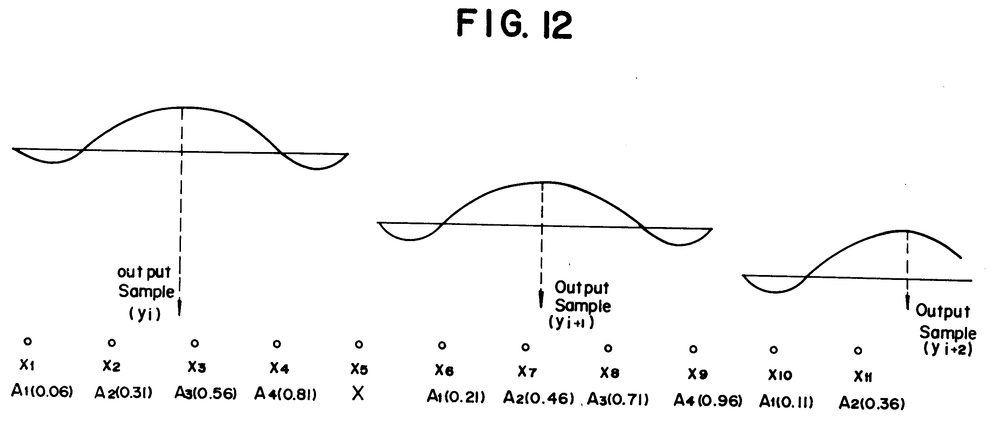

An understanding of the operation of the overflow check circuit shown in Figure 11 will be facilitated by reference to specific numerical values. Figure 12 illustrates waveforms similar to those shown in Figure 10 and juxtaposes those waveforms with respect to oversampled input data samples x₁, x₂, etc. As was described previously with reference to Figure 10, the illustrated impulse response characteristic is centred with respect to the time at which each output sample is to be produced.

Let is be assumed initially that the address of the first coefficient to be multiplied by the input data sample xᵢ for producing the output data sample yᵢ is 0.06. Then, the respective addresses of the coefficients to be multiplied by the subsequent oversampled input data samples x₂, x₃ and x₄ become:$\text{A2 = A1 + 0.25 = 0.31}$$\text{A3 = A2 + 0.25 = 0.56}$$\text{A4 = A3 + 0.25 = 0.81.}$
Since the averaged output sampling period Ts2(est)(i) is assumed to be 1.1, as described above, the output of the subtracter 16 is Ts2(est)(i) - 0.25 = 0.85. Thus, the coefficient address A4 falls within the range 0.75 < A4 < 0.85 and the comparator 15 controls the selector 17 to select the constant value 0.5. Hence, the address A1 of the coefficient to be multiplied by the next oversampled input data sample for calculating the output data sample yᵢ₊₁ becomes:$\text{A1 = A4 + 0.5 - Ts2(est)(i)} \text{= 0.81 + 0.5 - 1.1} \text{= 0.21.}$
As is apparent from Figure 12, the input data sample to be multiplied by the coefficient at the address A₁ is not x₅, which is the next sample and would be present at a time that the coefficient address would be A4 + 0.25 = 1.06. Rather, the sample x₅ is skipped. Hence, the next sample x₆ is multiplied by the coefficient at the address A1 = 0.21.

The addresses A2, A3, A4 of the coefficients to be multiplied by the subsequent oversampled input data samples x₇, x₈, x₉ are:$\text{A2 = A1 + 0.25 = 0.46}$$\text{A3 = A2 + 0.25 = 0.71}$$\text{A4 = A3 + 0.25 = 0.96.}$
Here, the coefficient address A4 complies with the relationship:$\text{A4 > Ts2(est)(i) - 0.25}$
and therefore the comparator 15 now controls the selector 17 to select the constant value 0.25. Thus, the address A1 of the coefficient to be multiplied by the next oversampled input data sample for calculating the next output data sample yᵢ₊₂ becomes$\text{A1 = A4 + 0.25 - Ts2(est)(i)} \text{= 0.96 + 0.25 - 1.1} \text{= 0.11.}$
From Figure 12, it can be seen that the next oversampled input data sample to be multiplied by the coefficient stored at the address A1 is the sample x₁₀.

As will be understood from the foregoing description, the output of the comparator 15 determines whether an oversampled input data sample is to be skipped. Hence, the comparator 15, like the comparator 14 of Figure 9, is used for controlling the read/write operations of the buffer 3 (Figure 5).

The above-described embodiment of Figures 8 to 12 calculates the averaged output sampling period Ts2(est)(i) by using a high speed clock signal produced by increasing the input data sampling frequency fs1 (or, alternatively, the output data sampling frequency fs2) many times over, that is by a factor 2^{k}. As a result, the sampling frequency converter of this embodiment employs a PLL operating at a high speed for generating that clock signal, and the PLL requires a sufficiently wide capture range to follow variations in frequency of the sampling clock signal Fs1 or Fs2 which it multiplies. Further, it may be difficult to synchronise the DSP which calculates the approximate values of the output data samples because the DSP operates in response to the high speed clock signal generated by the PLL. Additionally in the above-described embodiment, the averaging process for determining the averaged output sampling period Ts2(est)(i) to improve accuracy in the sampling rate conversion is carried out in a so-called open-loop calculation or averaging method based on the z-Transform${\text{H(z) = (1 - z}}^{\text{-n}} \text{) / (1 - z⁻¹)} {\text{= 1 + z⁻¹ + z⁻² + ... + z}}^{\text{-n+1}} \text{.}$
Using this averaging method, if a step form phase error occurs, a control error is produced.

The above-noted difficulties encountered in the embodiment just described can be overcome by a technique disclosed in European Patent Application No. 94101859.0 (Publication No. EP-A-0 599 817) which was divided from the present application.

## Claims

1. A sampling frequency converter for converting sampled input data having an input sampling frequency into sampled output data having a selected output sampling frequency, the converter comprising:
circuit means (5, 6) for determining a relative ratio between periods of input data samples and output data samples and generating an output signal representing the relative ratio;
averaging means (7, 8, 10) for averaging said output signal of said circuit means (5, 6) for a predetermined time duration and generating an averaged output;
filter coefficient generating means responsive to said averaged output for generating data representative of a set of predetermined filter coefficients derived from a low pass filter impulse response, said filter coefficient generating means including an addressable memory for storing said set of predetermined filter coefficients, means (12) for providing a fixed value as a function of said generated averaged output, and adder means (18) for adding said averaged output, said fixed value and an output of said adder means (18) for generating a memory address for reading out a filter coefficient; and
sampling filter circuit means (2) for converting said sampled input data into said sampled output data in response to said filter coefficients.

2. A converter according to claim 1, wherein said circuit means (5, 6) includes a phase locked loop circuit (5) connected to be supplied with a clock signal representing the frequency of one of said sampled input and sampled output data for frequency multiplying the supplied clock signal to generate a counting signal, and counter means (6) for counting said counting signal during every period of a clock signal representing the frequency of the other of said sampled input and sampled output data, thereby generating said output signal representing the relative ratio.

3. A converter according to claim 1 or claim 2, wherein said averaging means (7, 8, 10) includes a circuit having a transfer function H(Z) = (1-z⁻ⁿ)/(1-z⁻¹).

4. A converter according to claim 1, claim 2 or claim 3, wherein said means (12) for providing a fixed value as a function of said generated averaged output comprises an overflow check circuit connected to be supplied with the output of said adder means (18) to generate a control signal for selecting said fixed value.

5. A method of converting sampled input data having an input sampling frequency into sampled output data having a selected output sampling frequency, the method comprising the steps of:
determining (5, 6) a relative ratio between a period of the input data samples and a period of the output data samples;
averaging (7, 8, 10) said relative ratio for a predetermined time duration;
generating predetermined filter coefficients derived from a low pass filter impulse response in response to the averaged relative ratio, said generation of predetermined filter coefficients comprising storing in addressable memory a set of predetermined filter coefficients, providing (12) a fixed value as a function of the averaged relative ratio, generating (18) a summation output by adding the averaged relative ratio, said fixed value and said summation output, and using the summation output to generate a memory address; and
converting (2) said sampled input data into said sampled output data in response to said filter coefficients.

6. A method according to claim 5, wherein the step of determining a relative ratio comprises providing an input clock signal having the input sampling frequency and providing an output clock signal having the output sampling frequency, frequency multiplying (5) a selected one of the input or output clock signals, and counting (6) the frequency-multiplied clock signals during every period of the other non-multiplied clock signal, thereby generating an output signal representing the relative ratio.

7. A method according to claim 5 or claim 6, wherein said fixed value is provided only when said summation output is less than said averaged relative ratio and said output sampling frequency exceeds said input sampling frequency.

8. A method according to claim 5 or claim 6, wherein a first said fixed value is provided when said summation output falls within a range between first and second amounts, said second amount being a predetermined fraction of said averaged relative ratio, and a second said fixed value is provided when said summation output is less than said first amount or greater than said second amount, provided that said output sampling frequency is less than said input sampling frequency.

## Patentansprüche

1. Abtastfrequenzumsetzer zum Umsetzen abgetasteter Eingangsdaten mit einer Eingangsabtastfrequenz in abgetastete Ausgangsdaten mit einer ausgewählten Ausgangsabtastfrequenz, wobei der Umsetzer umfaßt:
Schaltungsmittel (5, 6) zur Bestimmung eines Relativverhältnisses zwischen Perioden von Eingangsdatenabtastproben und Ausgangsdatenabtastproben und zur Erzeugung eines das Relativverhältnis repräsentierenden Ausgangssignals;
mittelwertbildende Mittel (7, 8, 10) zur Mittelwertbildung des Ausgangssignals der Schaltungsmittel (5, 6) für eine bestimmte Zeitdauer und Erzeugen eines gemittelten Ausgangssignals;
Filterkoeffizientenerzeugungsmittel, welche auf das gemittelte Ausgangssignal zur Erzeugung von Daten reagieren, welche repräsentativ für einen Satz von vorgegebenen Filterkoeffizienten sind, die von einer Tiefpaßfilterimpulsantwort hergeleitet worden sind, wobei die Filterkoeffizientenerzeugungsmittel einen adressierbaren Speicher zur Speicherung des Satzes vorgegebener Filterkoeffizienten, Mittel (12) zur Bereitstellung eines festen Wertes als eine Funktion des erzeugten gemittelten Ausgangssignals und Additionsmittel (18) zum Addieren des gemittelten Ausgangssignals, des festen Wertes und eines Ausgangssignals der Additionseinrichtung (18) zur Erzeugung einer Speicheradresse zum Auslesen eines Filterkoeffizienten enthalten; und
Abtastfilterschaltungsmittel (2) zum Umsetzen der abgetasteten Eingangsdaten in abgetastete Ausgangsdaten als Reaktion auf die Filterkoeffizienten.

2. Umsetzer nach Anspruch 1, bei welchem die Schaltungsmittel (5, 6) eine Phase-Locked-Loop-Schaltung (5), die so angeschlossen ist, daß sie ein Taktsignal empfängt, welches die Frequenz eines von abgetastetem Eingangs- und abgetastetem Ausgangsdatenwert repräsentiert, zur Frequenzvervielfachung des zugeführten Taktsignals, um ein Zählsignal zu erzeugen, und einen Zähler (6) zum Zählen des Zählsignals während jeder Periode eines Taktsignals enthalten, welches die Frequenz des anderen von abgetastetem Eingangs- und abgetastetem Ausgangsdatenwertes repräsentiert, um auf diese Weise das das Relativverhältnis repräsentierende Ausgangssignal zu erzeugen.

3. Umsetzer nach Anspruch 1 oder 2, bei welchem die mittelwertbildenden Mittel (7, 8, 10) eine Schaltung mit einer Übertragungsfunktion H(Z) = (1 - z⁻ⁿ)/(1 - z⁻¹) enthalten.

4. Umsetzer nach Anspruch 1, 2 oder 3, bei welchem die Mittel (12) zur Bereitstellung eines festen Wertes als eine Funktion des erzeugten gemittelten Ausgangssignals eine Überlaufkontrollschaltung umfassen, die so angeschlossen ist, daß sie das Ausgangssignal der Additionsmittel (18) empfängt, um ein Steuersignal zur Auswahl des festen Wertes zu erzeugen.

5. Verfahren zum Umsetzen abgetasteter Eingangsdaten mit einer Eingangsabtastfrequenz in abgetastete Ausgangsdaten mit mit einer ausgewählten Ausgangsabtastfrequenz, wobei das Verfahren folgende Schritte umfaßt:
Bestimmung (5, 6) eines Relativverhältnisses zwischen einer Periode der Eingangsdatenabtastproben und einer Periode der Ausgangsdatenabtastproben;
Mittelwertbildung (7, 8, 10) des Relativverhältnisses für eine vorgegebene Zeitdauer;
Erzeugung vorgegebener Filterkoeffizienten, welche von einer Tiefpaßfilterimpulsantwort als Reaktion auf das gemittelte Relativverhältnis hergeleitet worden sind, wobei die Erzeugung der vorgegebenen Filterkoeffizienten das Speichern eines Satzes von vorgegebenen Filterkoeffizienten in einem adressierbaren Speicher, das Bereitstellen (12) eines festen Wertes als eine Funktion des gemittelten Relativverhältnisses, das Erzeugen eines Summenausgangssignals durch Addition des gemittelten Relativverhältnis, des festen Wertes und des Summenausgangssignals und die Verwendung des Summenausgängssignals, um eine Speicheradresse zu erzeugen, umfaßt; und
Umsetzen (2) der abgetasteten Eingangsdaten in die abgetasteten Ausgangsdaten als Reaktion auf die Filterkoeffizienten.

6. Verfahren nach Anspruch 5, bei welchem der Schritt zur Bestimmung eines Relativverhältnisses die Bereitstellung eines Eingangstaktsignals mit der Eingangsabtastfrequenz und das Bereitstellen eines Ausgangstaktsignals mit der Ausgangsabtastfrequenz, die Frequenzvervielfachung (5) eines ausgewählten von Eingangs- oder Ausgangstaktsignal und das Zählen (6) der frequenzvervielfachten Taktsignale während jeder Periode des anderen nicht vervielfachten Taktsignals umfaßt, um auf diese Weise ein das Relativverhältnis repräsentierendes Ausgangssignal zu erzeugen.

7. Verfahren nach Anspruch 5 oder 6, bei welchem der feste Wert nur bereitgestellt wird, wenn das Summenausgangssignal kleiner als das gemittelte Relativverhältnis ist, und die Ausgangsabtastfrequenz die Eingangsabtastfrequenz überschreitet.

8. Verfahren nach Anspruch 5 oder 6, bei welchem ein erster fester Wert bereitgestellt wird, wenn das Summenausgangssignal in einen Bereich zwischen ersten und zweiten Beträgen fällt, wobei der zweite Betrag ein vorgegebener Bruchteil des gemittelten Relativverhältnisses ist, und ein zweiter fester Wert bereitgestellt wird, wenn das Summenausgangssignal kleiner als der erste Betrag oder größer als der zweite Betrag ist, vorausgesetzt, daß die Ausgangsabtastfrequenz kleiner als die Eingangsabtastfrequenz ist.

## Revendications

1. Convertisseur de fréquence d'échantillonnage pour convertir des données d'entrée échantillonnées ayant une fréquence d'échantillonnage d'entrée en données de sortie échantillonnées ayant une fréquence d'échantillonnage de sortie sélectionnée, le convertisseur comprenant:
- des moyens de circuit (5, 6) pour déterminer un rapport relatif entre des périodes d'échantillons de données d'entrée et d'échantillons de données de sortie et produire un signal de sortie représentant le rapport relatif;
- des moyens d'obtention de valeur moyenne (7, 8, 10) pour obtenir la valeur moyenne dudit signal de sortie desdits moyens de circuits (5, 6) pendant une durée temporelle prédéterminée et produire un signal de sortie à valeur moyenne;
- des moyens générateurs de coefficients de filtre sensibles audit signal de sortie à valeur moyenne pour produire des données représentatives d'un ensemble de coefficients de filtre prédéterminés obtenus à partir de la réponse impulsionnelle d'un filtre passe-bas, lesdits moyens générateurs de coefficients de filtre comprenant une mémoire adressable pour mémoriser ledit ensemble de coefficients de filtres prédéterminés, des moyens (12) pour fournir une valeur fixe en fonction dudit signal de sortie à valeur moyenne produit et des moyens formant additionneur (18) pour additionner ledit signal de sortie à valeur moyenne, ladite valeur fixe et le signal de sortie desdits moyens formant additionneur (18) pour produire une adresse en mémoire pour lire un coefficient de filtre; et
- des moyens de circuit formant filtre d'échantillonnage (2) pour convertir lesdites données d'entrée échantillonnées en lesdites données de sortie échantillonnées en réponse auxdits coefficients de filtre.

2. Convertisseur selon la revendication 1, dans lequel lesdits moyens de circuit (5, 6) comprennent un circuit à boucle à phase asservie (5) connecté pour recevoir un signal d'horloge représentant la fréquence des unes desdites données d'entrée échantillonnées et de sortie échantillonnées pour multiplier en fréquence le signal d'horloge fourni pour produire un signal de comptage, et des moyens formant compteur (6) pour compter un signal pendant chaque période d'un signal d'horloge représentant la fréquence des autres desdites données d'entrée échantillonnées et de sortie échantillonnées, en produisant par ce moyen ledit signal de sortie représentant le rapport relatif.

3. Convertiseur selon la revendication 1 ou 2, dans lequel lesdits moyens d'obtention de valeur moyenne (7, 8, 10) comprennent un circuit ayant une fonction de transfert H(Z) = (1-z⁻ⁿ)/(1-z⁻¹).

4. Convertisseur selon la revendication 1, 2 ou 3, dans lequel lesdits moyens (12) pour fournir une valeur fixe en fonction dudit signal de sortie à valeur moyenne produit comprennent un circuit de contrôle de dépassement connecté pour recevoir le signal de sortie desdits moyens formant additionneur (18) pour produire un signal de commande pour sélectionner ladite valeur fixe.

5. Procédé pour convertir des données d'entrée échantillonnées ayant une fréquence d'échantillonnage d'entrée en données de sortie échantillonnées ayant une fréquence d'échantillonnage de sortie sélectionnée, le procédé comprenant les étapes consistant à:
- déterminer (5, 6) un rapport relatif entre une période des échantillons de données d'entrée et une période des échantillons de données de sortie;
- obtenir la valeur moyenne (7, 8, 10) dudit rapport relatif pendant une durée temporelle prédéterminée;
- produire des coefficients de filtre prédéterminés obtenus à partir de la réponse impulsionnelle d'un filtre passe-bas en réponse au rapport relatif à valeur moyenne, ladite génération de coefficients de filtre prédéterminés comprenant la mémorisation, dans une mémoire adressable, d'un ensemble de coefficients de filtre prédéterminés, la fourniture (12) d'une valeur fixe en fonction du rapport relatif à valeur moyenne, la génération (18) d'un signal de sortie de sommation en additionnant le rapport relatif à valeur moyenne, ladite valeur fixe et ledit signal de sortie de sommation, et en utilisant le signal de sortie de sommation pour produire une adresse en mémoire; et
- convertir (2) lesdites données d'entrée échantillonnées en lesdites données de sortie échantillonnées en réponse auxdits coefficients de filtre.

6. Procédé selon la revendication 5, dans lequel l'étape consistant à déterminer un rapport relatif comprend la fourniture d'un signal d'horloge d'entrée ayant la fréquence d'échantillonnage d'entrée et la fourniture d'un signal d'horloge de sortie ayant la fréquence d'échantillonnage de sortie, la multiplication en fréquence (5) d'un signal sélectionné parmi les signaux d'horloge d'entrée et de sortie, et le comptage (6) des signaux d'horloge multipliés en fréquence pendant chaque période de l'autre signal d'horloge non multiplié, en produisant ainsi un signal de sortie représentant le rapport relatif.

7. Procédé selon la revendication 5 ou 6, dans lequel ladite valeru fixe n'est fournie que lorsque ledit signal de sortie de dommation est inférieur audit rapport relatif à valeur moyenne et ladite fréquence d'échantillonnage de sortie est supérieure à ladite fréquence d'échatnillonnage d'entrée.

8. Procédé selon la revendication 5 ou la revendication 6, dans lequel une première dite valeur fixe est fournie lorsque ledit signal de sortie de sommation tombe dans unintervalle compris entre des premier et deuxième quantités, ladite deuxième quantité étant une fraction prédéterminée dudit rapport relatif à valeur moyenne, et une deuxième dite valeur fixe est fournie lorsque ledit signal de sortie de sommation est inférieur à ladite première quantité ou supérieur à ladite deuxième quantité, pourvu que ladite fréquence d'échantillonnage de sortie soit inférieure à ladite fréquence d'échantillonnage d'entrée.
